# DEMANDE DE BREVET EUROPEEN

(11) **EP 4 583 663 A1**
(43) Date de publication de la demande: **09.07.2025**
(21) Numéro de dépôt: 25150126.8
(22) Date de dépôt: 02.01.2025
(51) Int. Cl.: H10B 63/00, H10B 63/10, H10N 70/20

(54) **DISPOSITIF ELECTRONIQUE**

(30) Priorité: 02.01.2024 FR 2400013
(71) Demandeur: STMicroelectronics International N.V., 1228 Plan-les-Ouates, Geneva (CH)
(72) Inventeur: WEBER, Olivier, 38000 GRENOBLE (FR); BERTHELON, Remy, 38920 CROLLES (FR)
(74) Mandataire: Cabinet Beaumont

(57) **Abrégé**

La présente description concerne un circuit mémoire comprenant :
- un substrat semiconducteur (13) dans lequel sont disposés des transistors de sélection, le substrat semiconducteur (13) comportant des premières régions (27) et des deuxièmes régions (29), les première régions formant des premières lignes s'étendant dans une première direction (WL), les deuxièmes régions formant des deuxièmes lignes s'étendant dans la première direction (WL) ;
- un empilement d'interconnexion (35) comportant une succession de niveaux comportant des première (37) et deuxième (39) couches isolantes, dans lesquels sont définis des éléments d'interconnexion ;
- une pluralité de cellules mémoires (M) disposées au-dessus d'un niveau de l'empilement,
chaque cellule mémoire étant reliée à une première région par au moins un élément d'interconnexion, les deuxièmes régions d'une même deuxième ligne étant reliées entre elles par des éléments d'interconnexions situés dans lesdits au moins un niveau de l'empilement.

## Description

### Domaine technique

La présente description concerne de façon générale les dispositifs électroniques et plus particulièrement les dispositifs électroniques comprenant un circuit mémoire, en particulier un circuit mémoire à changement de phase.

### Technique antérieure

Un matériau à changement de phase est un matériau ayant la capacité de changer d'état cristallin sous l'effet de la chaleur et plus particulièrement de commuter entre un état cristallin et un état amorphe, plus fortement résistif que l'état cristallin. Ce phénomène est utilisé pour définir deux états mémoires, par exemple 0 et 1, différenciés par la résistance mesurée à travers le matériau à changement de phase.

Il existe un besoin d'amélioration des puces électroniques comportant un circuit mémoire comportant des cellules mémoires à base d'un matériau à changement de phase, et de leurs procédés de fabrication.

### Résumé de l'invention

Un mode de réalisation prévoit un dispositif électronique comprenant un circuit mémoire, le circuit mémoire comprenant :
- un substrat semiconducteur dans lequel sont disposés des transistors de sélection, le substrat semiconducteur comportant des premières régions dopées d'un premier type de conductivité et des deuxièmes régions, dopées d'un deuxième type de conductivité opposé au premier type de conductivité, les première régions formant des premières lignes s'étendant dans une première direction, les deuxièmes régions formant des deuxièmes lignes s'étendant dans la première direction ;
- un empilement d'interconnexion, disposé sur le substrat semiconducteur, comportant une succession de niveaux, chaque niveau comportant des première et deuxième couches isolantes, dans lesquels sont définis des éléments d'interconnexion ;
- une pluralité de cellules mémoires disposées au-dessus d'au moins un niveau de l'empilement d'interconnexion, chaque cellule mémoire étant reliée à une première région par au moins un élément d'interconnexion, les deuxièmes régions d'une même deuxième ligne étant reliées entre elles par des éléments d'interconnexions situés dans lesdits au moins un niveau de l'empilement d'interconnexion.

Selon un mode de réalisation, le substrat semiconducteur comprend, à partir d'une face supérieure :
- une troisième couche en le premier type de conductivité ;
- une quatrième couche en le deuxième type de conductivité, la quatrième couche étant située sur et en contact avec la troisième couche ; et
- une cinquième couche comprenant les premières et deuxièmes régions, la cinquième couche étant située sur et en contact avec la quatrième couche.

Selon un mode de réalisation, la quatrième couche, la troisième couche et les premières et deuxièmes régions de la cinquième couche constituent les transistors de sélection.

Selon un mode de réalisation, le dispositif comprend des premières tranchées s'étendant dans la première direction et des deuxièmes tranchées s'étendant dans une deuxième direction orthogonale à la première direction, les premières et deuxièmes tranchées divisant le substrat en ensembles, chaque ensemble comprenant une première région et une deuxième région.

Selon un mode de réalisation, les première et deuxième régions d'un ensemble sont séparées par une troisième tranchée, la troisième tranchée ayant une hauteur inférieure à la hauteur des premières et deuxièmes tranchées.

Selon un mode de réalisation, les deuxièmes tranchées ont une hauteur inférieure à la hauteur des premières tranchées, les première et deuxième régions d'un ensemble étant séparées par une troisième région semiconductrice.

Selon un mode de réalisation, chaque cellule mémoire est reliée électriquement à une première région par l'intermédiaire d'un premier via conducteur traversant toute l'épaisseur des au moins un niveau de l'empilement d'interconnexion.

Selon un mode de réalisation, le premier via conducteur est en un matériau métallique.

Selon un mode de réalisation, le premier via conducteur est en tungstène, en cobalt ou en cuivre.

Selon un mode de réalisation, les éléments d'interconnexion comprennent des deuxièmes vias conducteurs et des pistes conductrices, les pistes conductrices s'étendant latéralement sur une surface supérieure à la surface du deuxième via conducteur.

Selon un mode de réalisation, le dispositif comprend une alternance de première et deuxième ligne.

Selon un mode de réalisation, les deux lignes les plus proches de chaque première ou deuxième ligne sont une première et une deuxième ligne.

Selon un mode de réalisation, chaque cellule mémoire comprend une sixième couche en un matériau à changement de phase, un élément résistif en contact avec une face inférieure de la sixième couche et une septième couche conductrice en contact avec une face supérieure de la sixième couche.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B et la figure 1C représentent un mode de réalisation d'un dispositif électronique ;
la figure 2 représente un autre mode de réalisation d'un dispositif électronique ;
la figure 3A et la figure 3B représentent un autre mode de réalisation d'un dispositif électronique ; et
la figure 4 représente une variante des modes de réalisation décrits précédemment.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

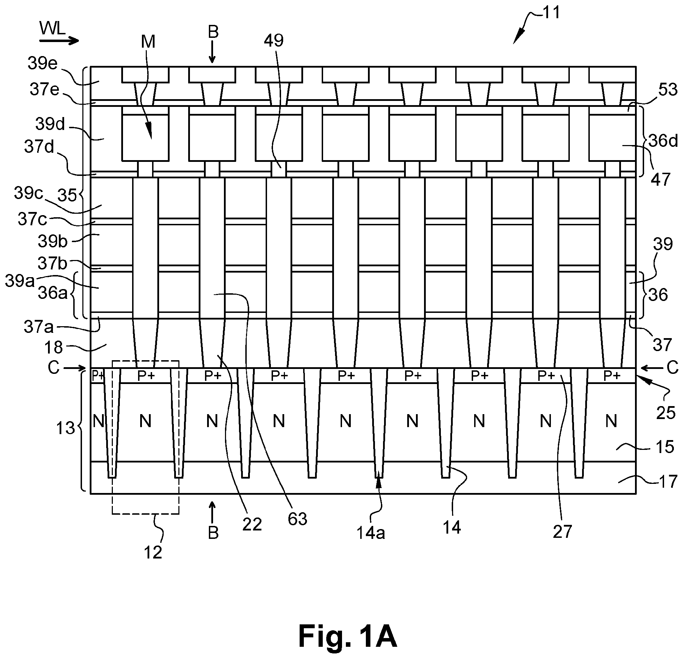

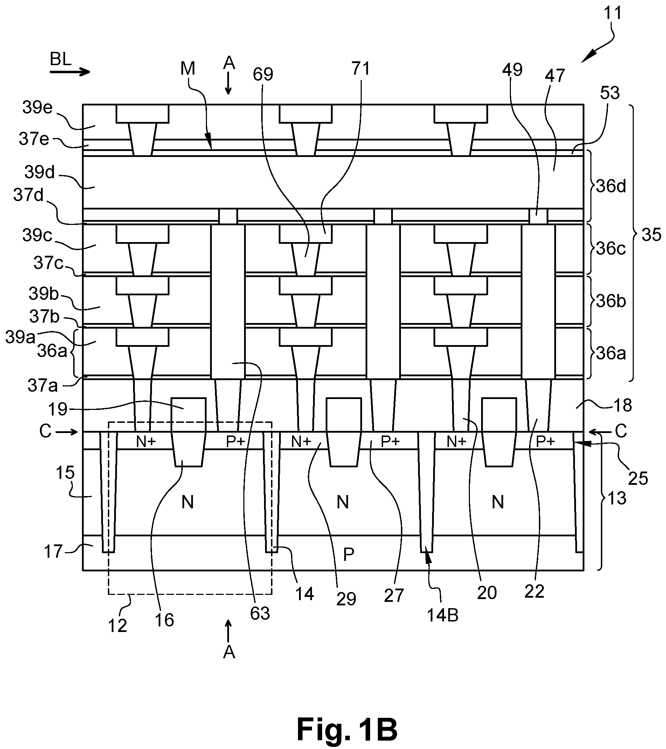

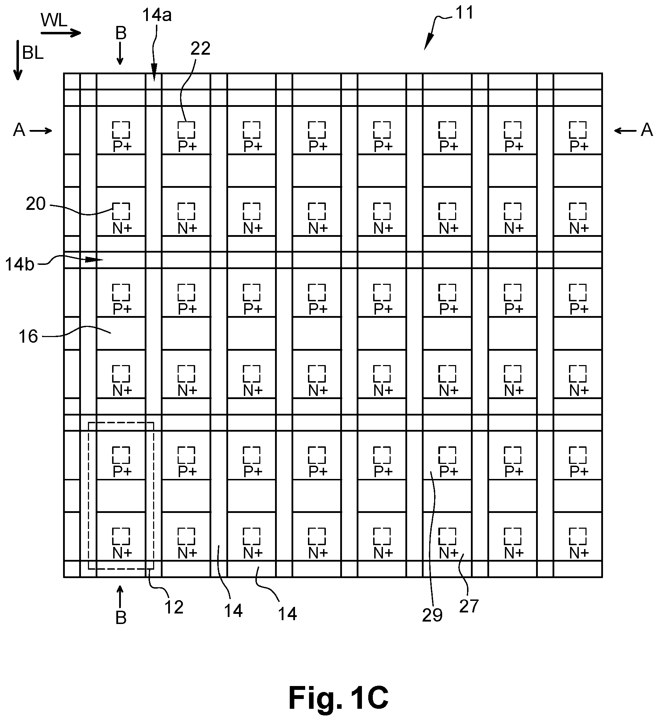

La figure 1A, la figure 1B et la figure 1C représentent un mode de réalisation d'un dispositif électronique 11, par exemple une puce électronique 11. Plus précisément, la figure 1A est une vue en coupe, partielle et schématique, selon un plan A-A des figures 1B et 1C. La figure 1B est une vue en coupe, partielle et schématique, selon un plan B-B des figures 1A et 1C. La figure 1C est une vue en coupe, partielle et schématique, selon un plan C-C des figures 1A et 1B.

Plus particulièrement, les figures 1A à 1C illustrent une portion d'un circuit mémoire de la puce électronique 11. A titre d'exemple, la puce électronique 11 comprend, dans une portion non représentée, un circuit logique adjacent au circuit mémoire. Les circuits logique et mémoire sont, par exemple, fabriqués simultanément dans et sur un même substrat semiconducteur.

La puce électronique comprend un substrat semiconducteur 13. A titre d'exemple, le substrat 13 est en silicium.

Le substrat 13 comprend, par exemple, une couche semiconductrice 15 dopée d'un premier type de conductivité, par exemple du type N, par exemple dopée d'atomes d'arsenic ou de phosphore. La couche 15 repose par exemple sur, et est par exemple en contact avec, une autre couche semiconductrice 17 du substrat 13 dopée d'un deuxième type de conductivité, opposé au premier type de conductivité, par exemple du type P, par exemple dopée d'atomes de bore.

Le substrat 13 comprend par exemple une couche semiconductrice 25. La couche 25 repose par exemple sur la couche 15. Ainsi, la couche 25 est séparée de la couche 17 par la couche 15. La couche 25 affleure par exemple une face supérieure du substrat 13.

Le substrat 13 est divisé en une pluralité d'ensembles 12. Les ensembles 12 sont de préférence agencés en matrice.

Le substrat comprend ainsi des lignes et des colonnes d'ensembles 12. Chaque ensemble 12 est associé à une cellule mémoire M, et est de préférence au moins partiellement en regard de ladite cellule mémoire M.

Les cellules mémoires M sont par exemple organisées, en vue de dessus, selon une matrice de lignes et de colonnes. On parle respectivement de lignes de mots (wordlines) et de lignes de bits (bitlines), chaque cellule mémoire M étant située à l'intersection d'une ligne de bits et d'une ligne de mots. A titre d'exemple, les cellules mémoires M illustrées en figure 1A sont des cellules mémoires M d'une même ligne de mots (WL) alors que les cellules mémoires illustrées en figure 1B sont des cellules mémoires d'une même ligne de bits (BL). En figure 1A, seulement huit lignes de bits sont représentées et en figure 1B seulement trois lignes de mots sont représentées. Toutefois, en pratique, un circuit mémoire peut comprend un nombre de lignes de bits et de lignes de mots différent, par exemple supérieur à huit et trois. La matrice d'ensembles 12 correspond donc sensiblement à la matrice de cellule mémoire M.

Les ensembles 12 sont séparés les uns des autres par des tranchées isolantes 14, ou tranchées d'isolation 14. Les tranchées isolantes 14 sont par exemple des tranchées d'isolation peu profondes (STI, de l'anglais " Shallow Trench Isolation"). Les tranchées 14 sont par exemple divisées en deux catégories : les tranchées 14a s'étendant dans une première direction, correspondant par exemple la direction des lignes de bits, et les tranchées 14b s'étendant dans une deuxième direction, correspondant par exemple à la direction des lignes de mots. Les tranchées d'isolation 14a et 14b sont, par exemple, orthogonales et forment une grille.

Les tranchées d'isolation 14 s'étendent, par exemple, à partir de la face supérieure du substrat, de préférence à partir de la face supérieure de la couche 15. Les tranchées 14 s'étendent de préférence dans la couche 25, dans la couche 15 et dans une partie de la couche 17. A titre d'exemple, chaque tranchée d'isolation 14b s'étend longitudinalement dans la direction des lignes de mots, sur toute la longueur des lignes de mots. A titre d'exemple, chaque tranchée d'isolation 14a s'étend longitudinalement dans la direction des lignes de bits, sur toute la longueur des lignes de bits. Les tranchées d'isolation 14 sont par exemple remplies d'un matériau diélectrique, par exemple de l'oxyde de silicium. La profondeur des tranchées 14 est par exemple comprise entre 250 nm et 400 nm.

Le substrat 13 comprend en outre des tranchées isolantes 16, ou tranchées d'isolation 16. Les tranchées 16 sont par exemple des tranchées d'isolation très peu profondes (SSTI, de l'anglais "Super Shallow Trench Isolation"). A titre d'exemple, chaque tranchée 16 s'étend longitudinalement dans la direction des lignes de mots, sur toute la longueur des lignes de mots. A titre d'exemple, les tranchées 16 s'étendent, verticalement, dans la couche 25 et dans la couche 15. Plus précisément, les tranchées 16 traversent la couche 25 et s'étendent dans une partie de la couche 15. Les tranchées 16 ont une hauteur inférieure à la hauteur des couches 25 et 15. Autrement dit, les tranchées 16 ne s'étendent pas jusqu'à la couche 17. Les tranchées 16 s'étendent par exemple à partir de la face supérieure de la couche 25. Les tranchées d'isolation 16 sont par exemple remplies d'un matériau diélectrique, par exemple de l'oxyde de silicium. La profondeur des tranchées 16 est par exemple comprise entre 20 nm et 40 nm.

Chaque tranchée 16 est située entre deux tranchées 14b. Ainsi, le substrat 13 comprend, dans la direction des lignes de bits, une alternance de tranchées 14b et de tranchées 16. Chaque ensemble 12 comprend ainsi une portion de tranchée 16. Les tranchées 16 divisent ainsi la portion de la couche 25 de chaque ensemble 12 en deux régions 27 et 29. Chaque ensemble 12 comprend ainsi une, de préférence une unique, région 27 et une, de préférence une unique, région 29. Les régions 27 et 29 d'un même ensemble 12 sont séparées par la tranchée 16.

Chaque région 27 ou 29 s'étend de préférence sur toute la hauteur de la couche 25. Chaque région 27 ou 29 affleure ainsi la face supérieure de la couche 25. Chaque région 27 ou 29 est par exemple en contact, par une face inférieure, avec la couche 15.

De préférence, les régions 27 d'ensembles 12 d'une même ligne, ou d'une même colonne, sont alignées. De même, les régions 29 d'ensembles 12 d'une même ligne, ou d'une même colonne, sont alignées. Le substrat 13 comprend, dans le mode de réalisation des figures 1A à 1C, des lignes de régions 27 s'étendant dans la direction des lignes de mots et des lignes de régions 29 s'étendant dans la direction des lignes de mots. Le substrat 13 comprend ainsi, dans l'exemple des figures 1A à 1C, des lignes comprenant une alternance de régions 27 et 29 s'étendant dans la direction des lignes de bits. Ainsi, dans la direction des lignes de bits, le substrat 13 comprend une alternance de lignes de régions 27 et de lignes de régions 29.

Les régions 27 sont par exemple dopées du deuxième type de conductivité, par exemple du type P. Les régions 27 sont, par exemple plus fortement dopées que la couche 17. Chaque région 27 est, par exemple surmontée d'une cellule mémoire M.

Les régions 29 sont par exemple dopées du premier type de conductivité, par exemple du type N. Les régions 29 sont, par exemple, plus fortement dopées que la couche 15. Les régions 29, à la différence des régions 27, ne sont pas surmontées de cellules mémoires M.

A titre d'exemple, la puce 11 comprend des motifs de grille 19 (en anglais "dummy gate") disposés sur la face supérieure de la couche 25, par exemple s'étendant longitudinalement dans la direction des lignes de mots. Les motifs de grille 19 s'étendent par exemple sur les tranchées 16, par exemple sur toute la longueur des tranchées. Ainsi, un motif de grille 19 est par exemple commun à tous les ensembles 12 formant une même ligne dans la direction des lignes de mots. Chaque motif de grille 19 est, par exemple en un matériau semiconducteur, par exemple en silicium, par exemple en silicium polycristallin.

La puce 11 comprend une couche isolante 18 recouvrant la face supérieure de la couche 25 et la face supérieure des motifs de grille 19. La couche isolante 18 est par exemple en contact avec la face supérieure de la couche 25 et des motifs de grille 19. La couche isolante 18 recouvre par exemple l'ensemble de la face supérieure de la couche 25. La couche isolante 18 a par exemple une épaisseur comprise entre 80 nm et 300 nm, par exemple comprise entre 120 nm et 200 nm.

La couche 18 comprend des vias conducteurs 20 et 22. Les vias 20 et 22 sont représentés en pointillés en figure 1C. Les vias 20 et 22 sont en contact avec la couche 25. Plus précisément, les vias 20 sont en contact, par une face inférieure, avec les régions 29 et les vias 22 sont en contact, par une face inférieure, avec les régions 27. Les vias 20 et 22 s'étendent par exemple sur toute la hauteur de la couche 18. Autrement dit, les vias 20 et 22 s'étendent de la face supérieure de la couche 18 à la face inférieure de la couche 18, c'est-à-dire, par exemple, de la face supérieure de la couche 18 à la face supérieure de la couche 25.

La couche 18 est surmontée d'un empilement d'interconnexion 35. L'empilement d'interconnexion 35 est par exemple formé sur la face supérieure de la couche isolante 18 et recouvre par exemple toute la surface de la couche isolante 18. L'empilement d'interconnexion 35 est par exemple formé d'une succession de niveaux 36, chaque niveau 36 comportant une couche isolante 37 et une couche isolante 39. L'empilement d'interconnexion 35 comprend par exemple un niveau 36a, comprenant une couche isolante 39a formée sur et en contact avec la face supérieure de la couche isolante 18. L'empilement d'interconnexion 35 comprend en outre une couche isolante 37a formée sur la couche isolante 39a. La couche isolante 37a est par exemple formée sur toute la surface de la couche isolante 39a. A titre d'exemple, la couche isolante 37a est en contact, par sa face inférieure, avec la face supérieure de la couche isolante 39a.

L'empilement d'interconnexion 35 peut en outre comprendre des niveaux supplémentaires formés sur le niveau 36a, c'est-à-dire sur et en contact avec la couche isolante 37a. En figures 1A, 1B et 1C, l'empilement d'interconnexion 35 comprend quatre niveaux supplémentaires par exemple formés respectivement des couches 37b et 39b, des couches 37c et 39c, des couches 37d et 39d et des couches 37e et 39e. En pratique, le nombre de niveaux dans l'empilement d'interconnexion 35 peut être différent de cinq, par exemple supérieur à cinq.

A titre d'exemple, l'empilement d'interconnexion 35 a une épaisseur comprise entre 300 nm et 800 nm, par exemple comprise entre 400 nm et 700 nm, par exemple de l'ordre de 500 nm.

A titre d'exemple, les couches isolantes 18 et 37 sont en un matériau de faible constante diélectrique, par exemple en un matériau ayant une constante diélectrique (correspondant à la permittivité dudit matériau par rapport à la permittivité du vide), inférieure à 5, par exemple inférieure à 4. Les couches isolantes 37 sont par exemple en nitrure de silicium ou en SiCN. A titre d'exemple, les couches isolantes 39 sont en un oxyde de faible permittivité, dits "low k" ou "ultra low k".

Chaque niveau 36 comprend des vias 69 et des pistes 71, les pistes 71 s'étendant dans la couche 39 par exemple à partir la face supérieure de la couche 39, affleurant ainsi la face supérieure de la couche 39. De préférence, les pistes 71 d'un niveau 36 s'étendent exclusivement dans la couche 39 dudit niveau 36. Les vias 69 d'un niveau de l'empilement 35 s'étendent à travers la couche 39 et à travers la couche 37. Plus précisément, les vias 69 d'un niveau de l'empilement 35 s'étendent de la face inférieure d'une piste 71 du même niveau à la face inférieure de la couche 37. De préférence, chaque via 69 d'un niveau de l'empilement 35 est en contact par une face supérieure à une face inférieure d'une piste 71 du même niveau 36 et est en contact, par une face inférieure, à la face supérieure d'une piste 71 du niveau inférieur ou à la face supérieure d'un via 20 ou 22 traversant la couche 18.

Les vias et pistes conductrices 71 et 69 sont par exemple en un matériau métallique, par exemple en cuivre. A titre d'exemple, les pistes conductrices 71 s'étendent latéralement sur une surface comprise entre 20 nm par 20 nm et 60 nm par 60 nm, par exemple de l'ordre de 30 nm par 30 nm. A titre d'exemple, les pistes conductrices 71 s'étendent latéralement sur une surface supérieure à la surface des vias 69.

Les cellules mémoires M sont, dans ce mode de réalisation, formées dans un niveau 36d de l'empilement 35. Le niveau 36d comprend les couches 37d et 39d. De manière plus générale, les cellules mémoires sont situées dans un niveau quelconque de l'empilement 35. De préférence, toutes les cellules mémoires sont situées dans un même niveau. Par exemple, les cellules mémoires sont situées dans un niveau situé au-dessus du niveau inférieur de l'empilement. Autrement dit, le niveau de l'empilement 35 comprenant les cellules mémoires M est de préférence séparé de la couche 18 par au moins un niveau de l'empilement 35.

A titre d'exemple, les cellules mémoires M sont des cellules mémoires à changement de phase et comprennent chacune une couche 47 en un matériau à changement de phase, par exemple un matériau chalcogènure, par exemple un alliage de germanium, antimoine et tellure (GeSbTe) dit GST. La couche 47 a, par exemple une épaisseur comprise entre 30 nm et 100 nm, par exemple, de l'ordre de 50 nm. La couche 47 est de préférence située, de préférence entièrement, dans la couche 39d. Les cellules mémoires M d'une même ligne de bits comprennent par exemple une couche 47 commune. Ainsi, la puce 11 comprend par exemple autant de couche 47 que de lignes de bits. Chaque couche 47 s'étend ainsi dans la couche 39d, dans la direction des lignes de bits.

Dans chaque cellule mémoire M, le matériau à changement de phase est, par exemple, contrôlé par un élément résistif métallique chauffant 49 situé sous le matériau à changement de phase. L'élément 49 est par exemple en contact, par sa face supérieure, avec la face inférieure de la couche 47. La face inférieure de chaque élément 49 est par exemple coplanaire avec la face inférieure de la couche 37 du niveau de l'empilement 35 dans lequel est situé la cellule mémoire M, c'est-à-dire la couche 37d dans l'exemple des figures 1A à 1C. A titre d'exemple, l'élément chauffant 49 a, par exemple, une épaisseur comprise entre 30 nm et 100 nm, par exemple de l'ordre de 60 nm.

La couche 47 est, par exemple surmontée par une couche 53, par exemple en un matériau conducteur, par exemple en un métal. Plus précisément, la face supérieure de chaque couche 47 est par exemple au moins partiellement recouverte, par exemple entièrement recouverte, par une couche 53. Chaque couche 53 s'étend de préférence, dans la direction des lignes de bits, sur toute la longueur de la couche 47. Dans l'exemple des figures 1A à 1C, chaque couche 53 est ainsi commune à toutes les cellules mémoires d'une même ligne de bit. La couche 53 est située dans le niveau 36d, de préférence dans la couche 39d, par exemple entièrement dans la couche 39d. Par exemple, la face supérieure de la couche 53 affleure la face supérieure de la couche 39d.

A titre d'exemple, dans chaque cellule mémoire M, l'élément métallique 49 et la couche 53 forment respectivement une électrode inférieure et une électrode supérieure de la cellule mémoire, et plus précisément de l'élément résistif à résistance variable formé par la couche 47 en le matériau à changement de phase. A titre d'exemple, les cellules mémoires M d'une même ligne de bits sont surmontées d'une même couche 53. En d'autres termes, les électrode supérieures 53 des cellules mémoires M d'une même ligne de bits sont interconnectées.

Les cellules mémoires M de lignes de bits voisines sont par exemple isolées les unes des autres par la couche isolante 39d et éventuellement la couche 37d.

Dans l'exemple des figures 1A à 1C, pour chaque cellule mémoire M, l'ensemble 12, comprenant la région 27 située à l'aplomb de la cellule mémoire M, la portion de la couche 15 située dans l'ensemble 12, la région 29 et la portion de la couche 17 située dans l'ensemble 12, définissent un transistor bipolaire, ici de type PNP, de sélection de la cellule mémoire M. Chaque cellule mémoire M est par exemple associée à un transistor bipolaire situé dans l'ensemble 12 situé en regard de la cellule mémoire. Dans cet exemple, la région 27 constitue une région d'émetteur du transistor, la région 15 et la région 29 constituent une région de base du transistor et la couche 17 constitue une région de collecteur du transistor. A titre d'exemple, le collecteur est commun à tous les transistors de la matrice et est, par exemple, connecté à la masse.

Chaque cellule mémoire M est connectée électriquement au transistor de sélection auquel elle est associée par l'intermédiaire d'un via conducteur 63 traversant tous les niveaux de l'empilement d'interconnexion 35 situés entre le niveau comprenant la cellule mémoire et la couche 18. A titre d'exemple, le via 63 traverse l'ensemble des couches isolantes 37 et 39 de l'empilement d'interconnexion 35 situées entre la couche 37d et la couche 18.

A titre d'exemple, le via 63 associé à chaque cellule mémoire M est en contact, par sa face supérieure, avec la face inférieure de l'élément résistif chauffant 49 de la cellule mémoire M. Le via 63 est par exemple en contact, par sa face inférieure, avec un via conducteur 22, lui-même en contact avec la face supérieure de la région 27 de l'ensemble 12 associé à la cellule mémoire M. Autrement dit, pour chaque cellule mémoire M, le via 63 correspondant relie électriquement l'élément chauffant 49 de la cellule mémoire à la région 27 sous-jacente.

Le via conducteur 63 est par exemple en un matériau métallique. Le via conducteur 63 est par exemple en tungstène. En variante, le via conducteur est en cobalt ou en cuivre. Le via conducteur 63 a, par exemple une largeur, prise dans le plan de la figure 1A et dans le plan de la figure 1B, comprise entre 20 nm et 80 nm, par exemple de l'ordre de 40 nm.

Les régions 29 de la couche 25 d'une même ligne de mots sont par exemple reliées entre elles par des vias conducteurs 69 et de pistes conductrices 71 situés dans des niveaux de l'empilement d'interconnexion 35 situés sous le niveau dans lesquelles sont situées les cellules mémoires. Ainsi, les vias conducteurs 69 et de pistes conductrices 71 reliant les régions 29 de la couche 25 d'une même ligne de mots sont situées entre le niveau comprenant les cellules mémoires et la couche 18. Dans l'exemple des figures 1A à 1C, les régions 29 sont reliées les unes aux autres par des vias 69 et des pistes 71 situées dans les niveaux 36a, 36b et 36c, c'est-à-dire dans les trois niveaux de l'empilement 35 les plus proches de la couche 18.

Ainsi, dans la direction des lignes de bits, la puce 11, et plus particulièrement le circuit mémoire, comprend une alternance de premières lignes, comprenant chacune une ligne de régions 29 et les pistes 71 et les vias 69 reliant lesdites régions 29, et de deuxièmes lignes, comprenant chacune une ligne de régions 27, les vias 63 en contact avec lesdites régions 27 et les cellules mémoires associées auxdites régions 27. Ainsi, chaque via 63 associé à une cellule mémoire M est séparé des vias 63 des lignes de mots voisines par les vias 69 et les pistes 71 reliant les régions 29 d'une ligne de régions 29.

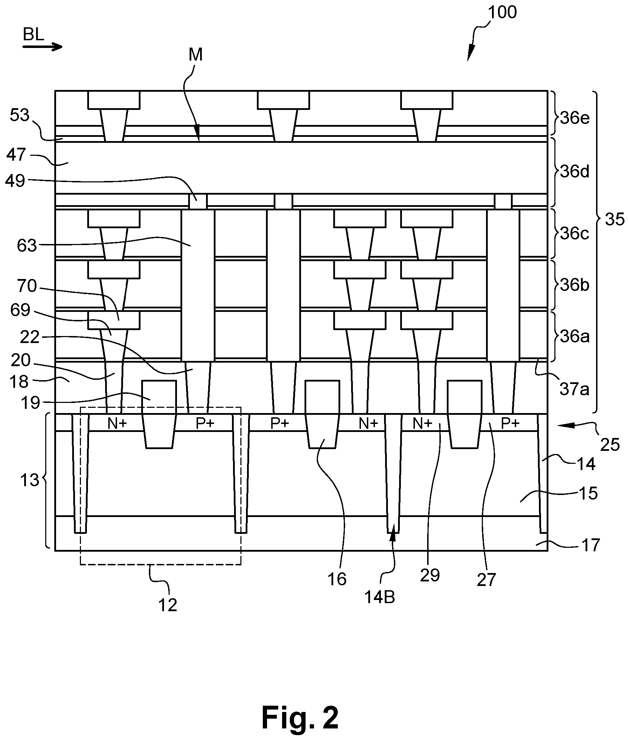

La figure 2 représente un autre mode de réalisation d'un dispositif électronique 100. Plus précisément, la figure 2 correspond à une vue en coupe, schématique et partielle, du dispositif 100 selon un plan similaire au plan de la figure 1B.

Le dispositif 100 comprend les éléments du dispositif 11 qui ne seront pas décrits de nouveau en détail.

Le dispositif 100 diffère du dispositif 11 des figures 1A à 1C en ce que le dispositif 100 comprend, dans la direction des lignes de bits (BL), une alternance d'ensembles 12, les régions 27 et 29 étant inversées d'un ensemble sur l'autre. Autrement dit, dans la direction des lignes de bits, chaque région 27 ou 29 est située entre une région 27 et une région 29. Ainsi, chaque région 27 ou 29 comprend, dans la direction des lignes de bits, une région 27 voisine et une région 29 voisine. Le dispositif 100 comprend des premières lignes de régions 27 et des deuxièmes lignes de régions 29, les premières et deuxièmes lignes s'étendant dans la direction des lignes de mots. Chaque première et deuxième ligne est située entre une première ligne et une deuxième ligne. Ainsi, les deux lignes les plus proches de chaque première ou deuxième ligne sont une première ligne et une deuxième ligne. Ainsi, chaque tranchée 14b sépare, de préférence directement, deux régions 27 ou deux régions 29. Chaque région 27 est séparée d'une région 29 par une tranchée 16 et d'une région 27 par une tranche 14b. Chaque région 29 est séparée d'une région 29 par une tranchée 14b et d'une région 27 par une tranche 16.

Comme dans les modes de réalisation décrits précédemment, chaque région 27 est surmontée par des vias 22 et 63 et par une cellule mémoire M. Chaque région 29 est surmontée d'un via 20 et d'une alternance de vias 69 et de pistes 71 reliant ensemble les régions 29 d'une même ligne de régions 29. Ainsi, chaque via 63 est situé entre un via 63 et une alternance de vias 69 et de piste 71.

La structure de la figure 2 comprend des régions 27 voisines et des régions 29 voisines. Les régions 27 voisines et les régions 29 voisines peuvent avantageusement être dopées simultanément, ce qui permet de former des ouvertures de masques plus grandes. En outre, un tel agencement permet de diminuer les dimensions des cellules mémoires. En effet, les régions 27 et 29 peuvent ainsi avoir des dimensions inférieures aux dimensions minimales des procédés de formation de régions semiconductrices.

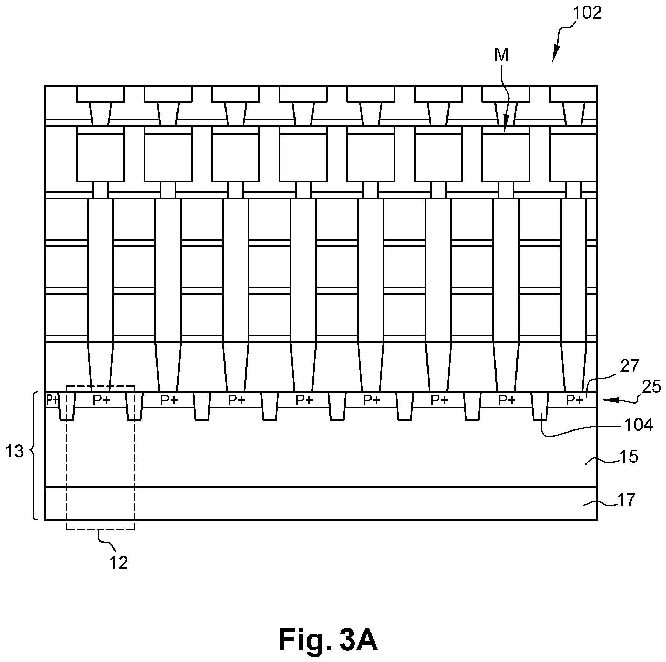

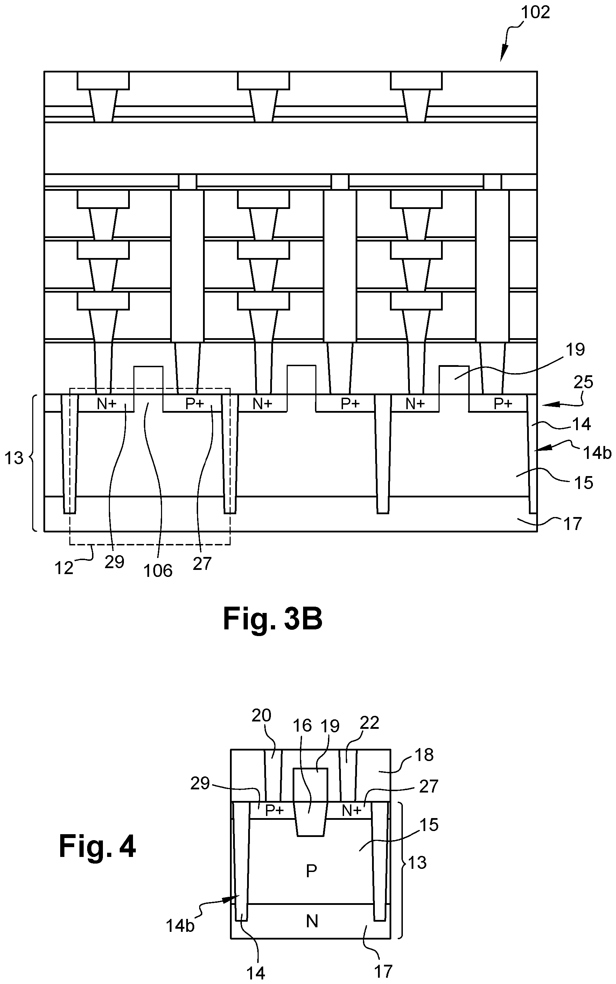

La figure 3A et la figure 3B représentent un autre mode de réalisation d'un dispositif électronique 102. Plus précisément, la figure 3A correspond à une vue en coupe, schématique et partielle, du dispositif 102 selon un plan A-A de la figure 3B et la figure 3B correspond à une vue en coupe, schématique et partielle, du dispositif 102 selon un plan B-B de la figure 3A.

Le dispositif 102 comprend les éléments du dispositif 11 qui ne seront pas décrits de nouveau en détail.

Le dispositif 102 diffère du dispositif 11 des figures 1A à 1C en ce que les tranchées 14a sont remplacées par des tranchées d'isolation 104. Les tranchées 104 sont par exemple des tranchées d'isolation très peu profondes (SSTI, de l'anglais "Super Shallow Trench Isolation"). A titre d'exemple, les tranchées 104 s'étendent, verticalement, dans la couche 25 et dans la couche 15. Plus précisément, les tranchées 104 traversent la couche 25 et s'étendent dans une partie de la couche 15. Les tranchées 104 ont de préférence une hauteur inférieure à la hauteur des couches 25 et 15. Autrement dit, les tranchées 104 ne s'étendent de préférence pas jusqu'à la couche 17. Les tranchées 104 s'étendent par exemple à partir de la face supérieure de la couche 25. Les tranchées d'isolation 104 sont par exemple remplies d'un matériau diélectrique, par exemple de l'oxyde de silicium. La profondeur des tranchées 104 est par exemple comprise entre 20 nm et 40 nm.

En outre, le dispositif 102 diffère du dispositif 11 en ce que le dispositif 102 ne comprend pas les tranchées 16 séparant les régions 27 et 29 d'un même ensemble 12. Les régions 27 et 29 d'un même ensemble 12 sont ainsi séparées par une région 106 de la couche 25. Chaque région 106 est ainsi située, dans la couche 25, à l'emplacement de la tranchée 16. Les régions 106 sont de préférence en le même matériau semiconducteur que la couche 15, par exemple en silicium. Les régions 106 sont par exemple dopées du même type de conductivité que la couche 15. Les régions 106 ont par exemple la même concentration de dopants que la couche 15. De préférence, les régions 106 ont une concentration de dopants inférieure à la concentration de dopants dans les régions 29.

Un avantage du mode de réalisation de la figure 3 est qu'il évite de mettre en oeuvre un procédé de fabrication double tranchées isolantes peu profondes avec deux profondeurs qui implique une double gravure de tranchées, un double remplissage, et une double étape de planarisation. Un tel procédé est coûteux et long.

La figure 4 représente une variante des modes de réalisation décrits précédemment. Plus précisément, la figure 4 représente une partie du mode de réalisation de la figure 1B selon une variante.

Dans la variante de la figure 4, les types de conductivité des couches et régions du substrat 13 sont inversées. Ainsi, la couche 17 est dopée de type N, la couche 15 est dopée de type P, les régions 27 sont dopées de type N et les régions 29 sont dopées, plus fortement que la couche 15, de type P. Ainsi, le transistor de sélection de chaque cellule mémoire est un transistor bipolaire de type NPN.

Un avantage du mode de réalisation des figures 1A à 1C est que la distance entre les cellules mémoires est sensiblement constante, ce qui permet d'éviter les perturbations d'une cellule à l'autre.

Un avantage du mode de réalisation de la figure 2 est que les régions 27 voisines et les régions 29 voisines peuvent être dopées simultanément, ce qui permet de former des ouvertures de masques plus grandes.

Un avantage des modes de réalisation décrits comprenant les vias 63 est que l'absence de pistes conductrices dans les couches 37 diminue le risque de capacités parasites, et il n'est ainsi pas nécessaire de former les couches 37 en un matériau ayant une constante diélectrique faible.

Un avantage des modes de réalisation décrits comprenant les vias 63 est qu'il permet de s'affranchir des contraintes de dimensionnement des niveaux de métaux pour l'intégration des cellules PCM, la surface des vias 63 pouvant être inférieure à la surface d'une piste 71 à la surface de l'empilement d'interconnexion 35. Ce mode de réalisation ne comprend pas avantageusement de vias 69 et de pistes 71.

Un autre avantage des modes de réalisation décrits comprenant les vias 63 est que la formation des cellules mémoires au-dessus des niveaux 36 permet de s'affranchir des risques de contamination de la couche PCM de la cellule mémoire engendrés par la formation de l'empilement d'interconnexion et des différents niveaux métalliques 71 et 69.

Encore un autre avantage des modes de réalisation décrits comprenant les vias 63 est qu'ils sont compatibles avec les procédés et les parties logiques connus, la partie logique n'étant pas impactée.

Un avantage du mode de réalisation de la figure 4 est qu'un transistor bipolaire NPN présente en général un meilleur facteur Beta Ic/Ib qu'un transistor bipolaire PNP. Il y a donc potentiellement évacuation de moins de courant dans la base et de plus de courant dans le collecteur pour un même courant émetteur. Il y a ainsi moins de tension sur les lignes de mots.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que chaque région 27 soit reliée à la cellule mémoire par un via 22 et un via 63 unique traversant les niveaux de l'empilement 35 séparant la cellule mémoire et la couche 18, le via 63 peut être remplacé, dans l'ensemble des modes de réalisation décrits, par une succession de pistes 71 et de vias 69 situés dans les niveaux de l'empilement 35 séparant la cellule mémoire et la couche 18.

Enfin, la mise en oeuvre pratique des modes de réalisation et variantes décrits est à la portée de la personne du métier à partir des indications fonctionnelles données ci-dessus.

## Revendications

1. Dispositif électronique (11, 100, 102) comprenant un circuit mémoire, le circuit mémoire comprenant :
- un substrat semiconducteur (13) dans lequel sont disposés des transistors de sélection, le substrat semiconducteur (13) comportant des premières régions (27) dopées d'un premier type de conductivité (P, N) et des deuxièmes régions (29), dopées d'un deuxième type de conductivité (N, P) opposé au premier type de conductivité, les première régions formant des premières lignes s'étendant dans une première direction (WL), les deuxièmes régions formant des deuxièmes lignes s'étendant dans la première direction (WL) ;
- un empilement d'interconnexion (35), disposé sur le substrat semiconducteur (13), comportant une succession de niveaux, chaque niveau comportant des première (37) et deuxième (39) couches isolantes, dans lesquels sont définis des éléments d'interconnexion (63, 71, 69) ;
- une pluralité de cellules mémoires (M) disposées au-dessus d'au moins un niveau de l'empilement d'interconnexion (35),
chaque cellule mémoire étant reliée à une première région (27) par au moins un élément d'interconnexion (63, 69, 71), les deuxièmes régions (29) d'une même deuxième ligne étant reliées entre elles par des éléments d'interconnexions (69, 71) situés dans lesdits au moins un niveau de l'empilement d'interconnexion (35).

2. Dispositif selon la revendication 1, dans lequel le substrat semiconducteur (13) comprend, à partir d'une face supérieure :
- une troisième couche (17) en le premier type de conductivité ;
- une quatrième couche (15) en le deuxième type de conductivité, la quatrième couche étant située sur et en contact avec la troisième couche (17) ; et
- une cinquième couche (25) comprenant les premières (27) et deuxièmes (29) régions, la cinquième couche étant située sur et en contact avec la quatrième couche (15).

3. Dispositif selon la revendication 2, dans lequel la quatrième couche (15), la troisième couche (17) et les premières (27) et deuxièmes (29) régions de la cinquième couche (25) constituent les transistors de sélection.

4. Dispositif selon l'une quelconque des revendications 1 à 3, dans lequel le dispositif comprend des premières tranchées (14, 14b) s'étendant dans la première direction (WL) et des deuxièmes tranchées (14, 14a, 104) s'étendant dans une deuxième direction (BL) orthogonale à la première direction, les premières et deuxièmes tranchées divisant le substrat en ensembles (12), chaque ensemble (12) comprenant une première région (27) et une deuxième région (29).

5. Dispositif selon la revendication 4, dans lequel les première (27) et deuxième (29) régions d'un ensemble (12) sont séparées par une troisième tranchée (16), la troisième tranchée (16) ayant une hauteur inférieure à la hauteur des premières (14, 14b) et deuxièmes (14, 14a) tranchées.

6. Dispositif selon la revendication 4, dans lequel les deuxième tranchées (104) ont une hauteur inférieure à la hauteur des premières tranchées (14, 14b), les première (27) et deuxième (29) régions d'un ensemble (12) étant séparées par une troisième région semiconductrice (106).

7. Dispositif selon l'une quelconque des revendications 1 à 6, dans lequel chaque cellule mémoire (M) est reliée électriquement à une première région (27) par l'intermédiaire d'un premier via conducteur (63) traversant toute l'épaisseur des au moins un niveau de l'empilement d'interconnexion (35).

8. Dispositif selon la revendication 7, dans lequel le premier via conducteur (63) est en un matériau métallique.

9. Dispositif selon la revendication 7 ou 8, dans lequel le premier via conducteur (63) est en tungstène, en cobalt ou en cuivre.

10. Dispositif selon l'une quelconque des revendications 1 à 9, dans lequel les éléments d'interconnexion comprennent des deuxièmes vias conducteurs (69) et des pistes conductrices (71), les pistes conductrices (71) s'étendant latéralement sur une surface supérieure à la surface du deuxième via conducteur (63).

11. Dispositif selon l'une quelconque des revendications 1 à 10, dans lequel le dispositif comprend une alternance de première et deuxième ligne.

12. Dispositif selon l'une quelconque des revendications 1 à 10, dans lequel les deux lignes les plus proches de chaque première ou deuxième ligne sont une première et une deuxième ligne.

13. Dispositif selon l'une quelconque des revendications 1 à 12, dans lequel chaque cellule mémoire (M) comprend une sixième couche (47) en un matériau à changement de phase, un élément résistif (49) en contact avec une face inférieure de la sixième couche et une septième couche conductrice (53) en contact avec une face supérieure de la sixième couche.
